# EUROPEAN PATENT APPLICATION

(11) **EP 1 701 353 A1**
(43) Date of publication of application: **13.09.2006**
(21) Application number: 05005310.7
(22) Date of filing: 10.03.2005
(51) Int. Cl.: G11C 7/16, G06F 3/023

(54) **Portable electronic assembly with media playback function**

(71) Applicant: TOPSEED TECHNOLOGY CORP., Chung Ho City, Taipei Hsien, Taiwan 235 (TW)
(72) Inventor: Chen, Shoei-Lai, Chung-Ho City, Taipei Hsien, Taiwan 235 (TW)
(74) Representative: TER MEER - STEINMEISTER & PARTNER GbR

(57) **Abstract**

A portable electronic assembly with media playback function includes a portable electronic device with a first chamber and a second chamber separated by a partition plate, a built-in USB OTG (On-The-Go) chip and a USB OTG connection port in the second chamber, a cover for sealing the first chamber and the second chamber; and a portable storage unit arranged in the second chamber. The portable storage unit includes a USB interface electrically connected to the USB OTG connection port. Therefore, the portable electronic assembly has media playback function for MP3 playback, digital audio and video data transmission, sharing and playback without using a host computer. The portable electronic assembly further includes earphone and control keys to function as MP3 player.

## Description

### BACKGROUND OF THE INVENTION

### 1. Field of the Invention

The present invention relates to a portable electronic assembly with media playback function, and more particularly to a portable electronic assembly with built-in USB OTG chip and chamber for media playback, whereby the portable electronic assembly functions as master for real-time MP3 playback, digital audio and video data transmission, sharing and playback with low cost and great portability.

### 2. Description of Related Art

The consumer electronic product and electronic storage media have rapid progress recently as the advance of electronic technology and prevailing of computer system. The electronic storage media and related devices, such as hard disk, flash memory card, thumb drive, MP3 device, card reader, are generally provided to the consumer electronic product for data storage. However, the prior art consumer electronic product is generally connected to a host computer through USB port to upload or download data for the electronic storage media thereof. The data transfer cannot be fulfilled without activating the host computer. Taking MP3 player as example, the MP3 data should be transferred from the host computer to the MP3 player through the USB interface for later playback. For data file transfer, the data is sent from the host computer to the thumb drive or flash memory card through USB interface. However, the content of the data file is only manifested by the host computer. Therefore, the thumb drive or flash memory card needs to connect with the host computer to manifest the content thereof, which imposes limitation on usage thereof.

Moreover, the mobile or portable electronic devices such as remote controllers for audio/video apparatus, remote controllers for computer cursor, or remote controllers for projector are also extensively used in ordinary life. However, those remote controllers are generally applicable to specific devices. Therefore, for user having lots of electronic device, he may need to bring remote controller, hard disk, flash memory card, thumb drive, MP3 device, card reader to successfully access the desired function. It is inconvenient to user because a bulky host computer is often required.

The USB On-The-Go (USB OTG) is developed to overcome the drawback of the conventional USB 2.0 protocol. The USB OTG supports bi-directional transmission function for the host computer and USB OTG peripheral in contrast to master-slave architecture of conventional USB 2.0 protocol.

In other word, the USB OTG peripheral can be a master for data transmission and performs data access and data sharing without the aid of host computer, which is great advance over merely original plug-and-play and peripheral function supported by the USB 2.0 protocol. However, it is still a challenge to integrate the function of conventional device end product with USB interface such as remote controller, hard disk, flash memory card, thumb drive, MP3 device, and card reader.

### SUMMARY OF THE INVENTION

The present invention provides a portable electronic assembly with built-in USB OTG chip and chamber for media playback without using a host computer, whereby the portable electronic assembly functions as master for real-time MP3 playback, digital audio and video data transmission, sharing and playback with low cost and great portability.

Accordingly, the portable electronic assembly according to the present invention comprises a portable electronic device with a first chamber and a second chamber separated by a partition plate, a built-in USB OTG chip and a USB OTG connection port in the second chamber, a cover for sealing the first chamber and the second chamber; and a portable storage unit arranged in the second chamber. The portable storage unit includes a USB interface electrically connected to the USB OTG connection port.

Moreover, according to a preferred embodiment of the present invention, the portable electronic assembly is a remote controller.

Moreover, according to another preferred embodiment of the present invention, the portable storage unit is a USB storage unit with wireless transmission/reception function, or an ordinary wired USB storage unit. The portable storage unit is a thumb drive, an MP3 player, or a thumb drive with MP3 function.

### BRIEF DESCRIPTION OF DRAWING

The features of the invention believed to be novel are set forth with particularity in the appended claims. The invention itself however may be best understood by reference to the following detailed description of the invention, which describes certain exemplary embodiments of the invention, taken in conjunction with the accompanying drawings in which:
Fig. 1 shows an exploded view of a preferred embodiment of the present invention.
Fig. 2 shows a perspective view of a preferred embodiment of the present invention.
Fig. 3 shows another perspective view of a preferred embodiment of the present invention with a control panel.
Fig. 4 shows a flowchart for operating the portable electronic assembly according to the present invention.

### DETAILED DESCRIPTION OF THE INVENTION

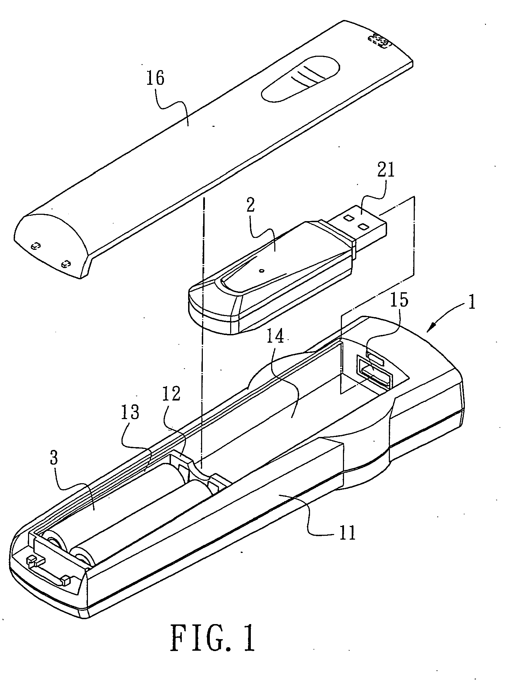

With reference to Figs. 1 to 3, the present invention provides a portable electronic assembly with media playback function. The portable electronic assembly comprises a portable electronic device 1 and a portable storage unit 2 arranged in the portable electronic device 1.

The portable electronic device 1 comprises a main body 11 with an inner space, a partition plate 12 dividing the inner space into a first chamber 13 and a second chamber 14, and a cover 16 sealing the first chamber 13 and the second chamber 14. The first chamber 13 is used for receiving a battery 3 therein as working power source. A USB OTG chip (not shown) is placed in the second chamber 14 and a USB OTG port 15 is arranged within the second chamber 14.

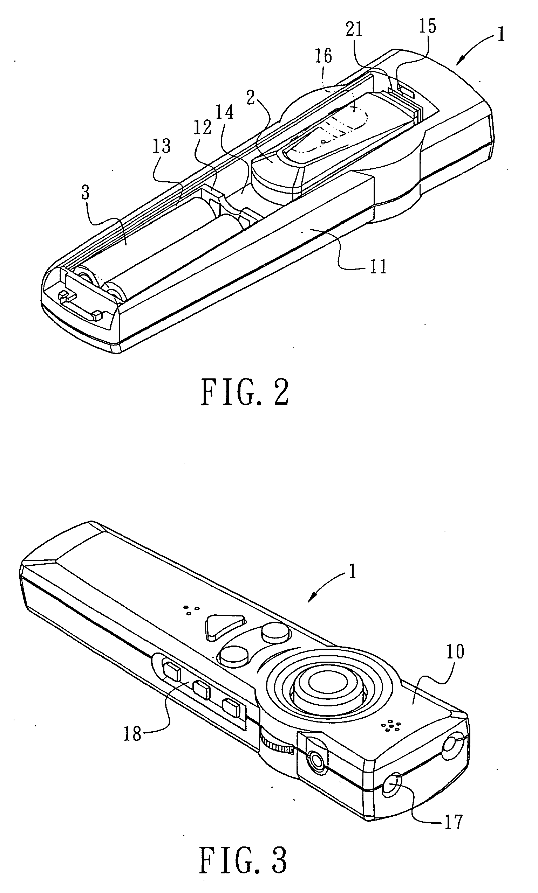

According to a preferred embodiment of the present invention, the portable electronic device 1 is a remote controller, such as a remote controller of audio/video apparatus, computer cursor, or projector. The portable electronic device 1 comprises a control panel 10 with an earphone socket 17 and control keys 18 for controlling the operation of the MP3 playback, digital data transfer, storing and accessing, as shown in Fig. 3.

The portable storage unit 2 comprises a USB interface 21 and is configured to fit into the second chamber 14. The USB interface 21 can be connected with the USB OTG port 15 in the second chamber 14, as shown in Fig. 2.

The portable storage unit 2 is, for example, a commercially available storage media of different formats, such as thumb drive, MP3 player, thumb drive with MP3 function etc. The portable storage unit 2 can be retained in the second chamber 14 by connecting to the USB OTG port 15, thus prevent from detaching or removing during the movement of the portable electronic device 1. Alternatively, the portable storage unit 2 can be a USB storage unit with wireless transmission/reception function, or an ordinary wired USB storage unit.

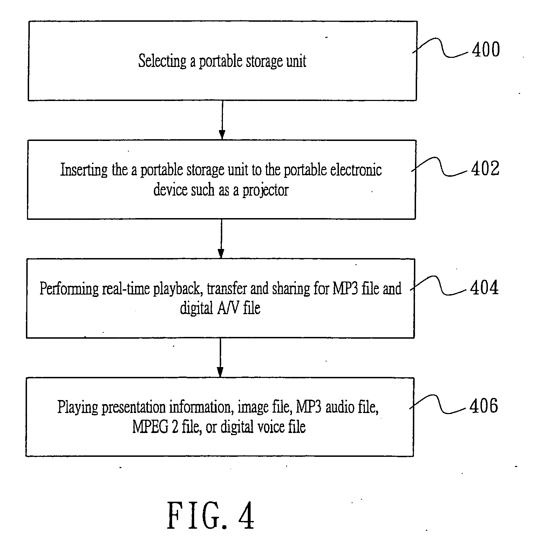

Fig. 4 shows a flowchart for operating the portable electronic assembly according to the present invention. In step 400, a portable storage unit 2 is selected, wherein the portable storage unit 2 can be a USB storage unit with -wireless -transmission/reception function, or an ordinary wired USB storage unit. In step 402, the portable storage unit 2 is inserted into the second chamber 14. As shown in Fig. 2, in this situation, the USB interface 21 is connected with the USB OTG port 15 in the second chamber 14.

Accordingly, the portable electronic device 1 can be directly used as flash memory or MP3 data storage. In step 404, a user can operate the control keys 18 to access the portable storage unit 2 without using a host computer or without the need to turn on a host computer. The digital data such as MP3 audio file, MPEG 2 file, digital voice file can be real-time play backed, accessed, transmitted or shared. In step 406, a user can use an earphone connected to the earphone socket 17 and operate the control keys 18 to playback the MP3 data and digital audio/video data.

Although the present invention has been described with reference to the preferred embodiment thereof, it will be understood that the invention is not limited to the details thereof. Various substitutions and modifications have suggested in the foregoing description, and other will occur to those of ordinary skill in the art. Therefore, all such substitutions and modifications are intended to be embraced within the scope of the invention as defined in the appended claims.

## Claims

1. A portable electronic assembly with media playback function, comprising:
a portable electronic device 1 with a built-in USB OTG (On-The-Go) chip and a USB OTG connection port 15; and
a portable storage unit 2 arranged in the portable electronic device 1 and electrically connected to the USB OTG connection port 15.

2. The portable electronic assembly as in claim 1, wherein the portable storage unit 2 functions as a flash memory or a MP3 data storage.

3. The portable electronic assembly as in claim 1, wherein the portable electronic device 1 comprises:
a main body 11;
a first chamber 13 and a second chamber 14 defined in the main body 11 and separated by a partition plate 12; wherein the built-in USB OTG chip and the USB OTG connection port 15 are placed in the second chamber 14; and
a cover 16 sealing the first chamber 13 and the second chamber 14.

4. The portable electronic assembly as in claim 3, wherein the portable electronic device 1 further comprises:
a control panel 10;
earphone socket 17 and control keys 18 on the control panel 10, wherein the control keys 18 function for MP3 playback, digital data transfer and accessing.

5. The portable electronic assembly as in claim 1, wherein the portable electronic device 1 is a remote controller.

6. The portable electronic assembly as in claim 1, wherein the portable electronic device 1 is a remote controller for audio/video apparatus, computer cursor, or projector.

7. The portable electronic assembly as in claim 1, wherein the portable storage unit 2 is a storage unit with USB interface 21 and adapted to support different formats.

8. The portable electronic assembly as in claim 1, wherein the portable storage unit 2 is a USB storage unit with wireless transmission/reception function, or an ordinary wired USB storage unit.

9. The portable electronic assembly as in claim 1, wherein the portable storage unit 2 is a thumb drive, an MP3 player, or a thumb drive with MP3 function.

10. A remote controller with MP3 playback function, comprising:
a remote controller unit comprising a chamber with a built-in USB OTG (On-The-Go) chip and a USB OTG connection port 15; and
a thumb drive configured to fit in the chamber and corresponding to the USB OTG connection port 15, the thumb drive functioning as a master device for MP3 playback, digital audio and video data transmission, sharing and playback.

11. A remote controller with flash memory playback function, comprising:
a remote controller unit comprising a chamber with a built-in USB OTG (On-The-Go) chip and a USB OTG connection port 15; and
a portable storage unit 2 configured to fit in the chamber and corresponding to the USB OTG connection port 15, the portable storage unit 2 functioning as a master device for MP3 playback, digital audio and video data transmission, sharing and playback.
